# EUROPÄISCHE PATENTSCHRIFT

(11) **EP 2 223 423 B1**
(45) Veröffentlichungstag und Bekanntmachung des Hinweises auf die Patenterteilung: **25.12.2019**
(21) Anmeldenummer: 08861164.5
(22) Anmeldetag: 31.10.2008
(51) Int. Cl.: H02M 7/219, H03K 17/06, H03K 17/687, H03K 17/74

(54) **GLEICHRICHTERSCHALTUNG**
RECTIFIER CIRCUIT
CIRCUIT REDRESSEUR

(30) Priorität: 14.12.2007 DE 102007060219
(43) Veröffentlichungstag der Anmeldung: 01.09.2010
(73) Patentinhaber: Robert Bosch GmbH, 70442 Stuttgart (DE); SEG Automotive Germany GmbH, 70499 Stuttgart (DE)
(72) Erfinder: GOERLACH, Alfred, 72127 Kusterdingen (DE); BAUR, Markus, 72108 Rottenburg (DE)
(86) Internationale Anmeldenummer: PCT/EP2008/064824
(87) Internationale Veröffentlichungsnummer: WO 2009/077257

(56) Entgegenhaltungen:
- EP-A- 0 321 663
- EP-A- 0 777 309
- EP-A- 1 521 354
- EP-A1- 1 134 886
- DE-A1- 10 336 237
- US-A- 5 602 508
- US-A1- 2002 141 214
- US-A1- 2005 017 694
- US-B1- 6 212 084
- REES S ET AL: "A smart synchronous rectifier for 12 V automobile alternators" PESC'03. 2003 IEEE 34TH. ANNUAL POWER ELECTRONICS SPECIALISTS CONFERENCE. CONFERENCE PROCEEDINGS. ACAPULCO, MEXICO, JUNE 15 - 19, 2003; [ANNUAL POWER ELECTRONICS SPECIALISTS CONFERENCE], NEW YORK, NY :; IEEE, US, Bd. 4, 15. Juni 2003 (2003-06-15), Seiten 1516-1521, XP010648456 ISBN: 978-0-7803-7754-7
- TIETZE U ET AL: "Halbleiter-Schaltungstechnik, Fuenfte Auflage" HALBLEITER- SCHALTUNGSTECHNIK, BERLIN, SPRINGER-VERLAG, DE, 1. Januar 1980 (1980-01-01), Seiten 111-113, XP002205656
- IAN ROBERTSON SINCLAIR: "Practical Electronics Handbook" 11. Februar 2000 (2000-02-11), NEWNES, ELSEVIER LTD. , OXFORD , XP002510291 Seite 56 - Seite 57; Abbildung 2.4
- Bennet, N. et al: "Power Semiconductor Applications", Philips Semiconductor , 31 December 1994 (1994-12-31), pages 445-446, Retrieved from the Internet: URL:http://www.thierry-lequeu.fr/data/APPC HP3.pdf [retrieved on 2011-02-04]

## Beschreibung

Die Erfindung betrifft eine Gleichrichterschaltung.

### Stand der Technik

Zur Erzeugung von Gleichspannungen aus Wechselspannungen werden derzeit meist Gleichrichterbrücken verwendet, die aus einer Zusammenschaltung von Dioden bestehen.

Die Umwandlung einer Wechselspannung in eine Gleichspannung erfolgt beispielsweise in einem Kraftfahrzeug, in welchem mittels eines Generators eine Wechselspannung erzeugt wird, die mittels einer nachgeschalteten Gleichrichterbrücke in eine Gleichspannung umgewandelt wird.

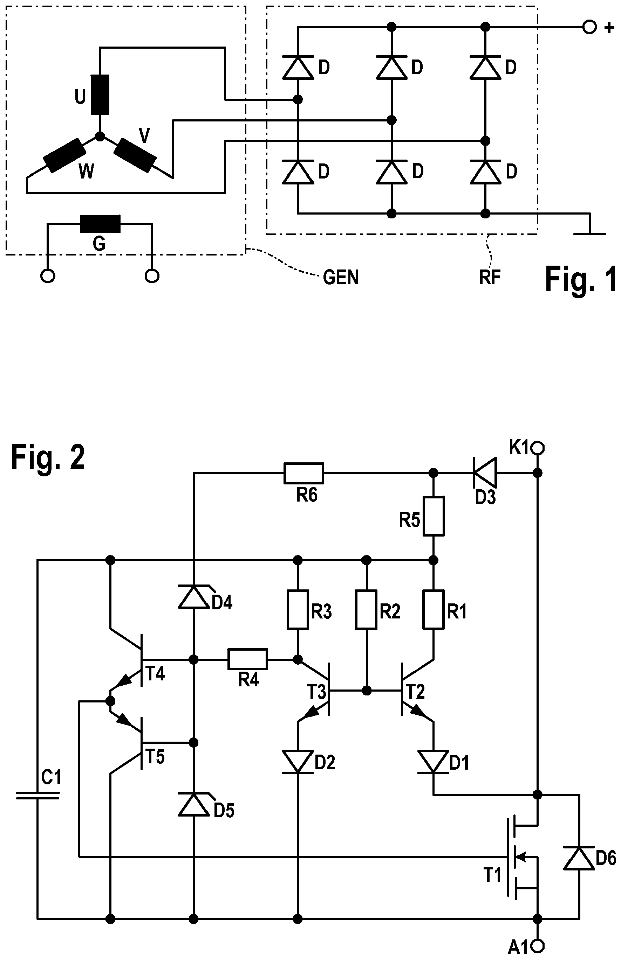

Ein Beispiel für eine derartige Spannungsversorgung eines Kraftfahrzeugs ist in der Figur 1 gezeigt. Diese enthält eine Generatorvorrichtung GEN, welche eine Erregerwicklung G und sternförmig geschaltete Phasenwicklungen U, V und W aufweist. Die an den Phasenwicklungen U, V und W bereitgestellten Phasenspannungen werden einer Gleichrichterbrücke RF zugeführt, welche an ihrem Ausgang die gewünschte Gleichspannung bereitstellt. Die Gleichrichterbrücke RF enthält drei Brückenzweige. In jedem dieser Brückenzweige sind zwei Silizium-PN-Dioden D vorgesehen.

Physikalisch bedingt kommt es bei einem Vorwärtsbetrieb von Silizium-PN-Dioden in Gleichrichteranwendungen zu Diodenflussspannungen von ca. 800 mV bis ca. 2 V. Diese Diodenflussspannungen lassen sich bei sinnvoller Dimensionierung üblicherweise nicht unter ca. 1 V absenken. Besonders bei einer Gleichrichtung niedriger Wechselspannungen entstehen deshalb beachtliche Leistungsverluste an den Gleichrichterdioden. Bei Generatoren, die der Spannungsversorgung von Personenkraftfahrzeugen dienen, betragen die gleichzurichtenden Wechselspannungen üblicherweise ca. 17 V Spitze-Spitze zwischen den Anschlüssen zweier Phasenwicklungen. Da der Strom über zwei Gleichrichterdioden fließt, entsteht durch die Gleichrichtung eine Spannungsreduktion im Mittel von ca. 2 V. Bei diesem Beispiel beträgt der Leistungsverlust im Gleichrichter bei entsprechender Last ca. 20 % der abgegebenen Leistung. Die im Gleichrichter umgesetzte Verlustleistung ist in Form von Wärme durch aufwendige Kühlelemente abzuführen. Zudem wirken sich die Leistungsverluste direkt auf den Kraftstoffverbrauch des jeweiligen Fahrzeugs aus.

Die Druckschrift Rees et al. "A Smart Synchronous Rectifier for 12 V Automobile Alternators PESC 03. 2003 IEEE 34th annual power electronics specialists conference june 15-19 2003 Bd. 4, Seiten 1516-1521" zeigt Ausführungsformen von Schaltungstopologien zur Realisierung von Aktivgleichrichtern auf der Basis von Operationsverstärkern für Gleichrichteranordnungen, die in Fahrzeugen zur Gleichrichtung der Ausgangsspannung eines Drehstromgenerators eingesetzt werden können. Der Umfang der zusätzlich benötigten Beschaltung hängt von der Wahl der eingesetzten Operationsverstärker ab, wobei diskrete Schaltungsteile aus Dioden und Kondensatoren erforderlich sind.

Aus der US 2002/0141214 A1 ist ein Synchrongleichrichter bekannt, welcher einen Kathodenanschluss, einen Anodenanschluss und eine zwischen dem Kathodenanschluss und dem Anodenanschluss vorgesehene elektronische Schaltung aufweist. Die elektronische Schaltung enthält einen MOS-Transistor mit Body-Diode, einen Kondensator und einen Spannungskomparator, dessen Ausgangssignal dem Gate des MOS-Transistors zugeführt wird.

Aus dem Artikel von Bennet, N. et al: "Power Semiconductor Applications", Philips Semiconductor, 31. Dezember 1994 (1994-12-31), Seiten 445 - 446, ist ein 3 pin TOPFET (Temperature and Overload Protected MOSFET) bekannt, welcher ein zwischen dem Drainanschluss und dem Gateanschluss des TOPFETS angeordnetes Klemmelement, eine zwischen dem Sourceanschluss des TOPFETS und dem Gateanschluss des TOPFETS angeordnete Zenerdiode und eine zwischen dem Sourceanschluss und einem Eingangsanschluss des TOPFETS angeordnete weitere Zenerdiode aufweist.

Aus der US 2005/017694 A1 ist ein Schalter für eine Gleichrichterbrücke bekannt, welcher eine zwischen dem Pluspol einer Batterie und einem Phasenanschluss der Gleichrichterbrücke angeordnete elektronische Schaltung aufweist. Die elektronische Schaltung enthält einen Treiber, einen MOS-Feldeffekttransistor und eine zwischen dem Pluspol der Batterie und dem Gate des MOS-Feldeffekttransistors angeordnete Reihenschaltung einer als Spannungsbegrenzungselement dienenden Zenerdiode und einer Schutzdiode für den Treiber.

Aus der DE 103 36 237 A1 ist ein Gleichrichter mit Selbststeuerung bekannt, welcher einen Kathodenanschluss, einen Anodenanschluss und eine zwischen dem Kathodenanschluss und dem Anodenanschluss angeordnete elektronische Schaltung aufweist.

Die elektronische Schaltung enthält einen MOS-Transistor mit integrierter Reversdiode, einen Kondensator, weitere MOS-Transistoren, einen Operationsverstärker und Widerstände. Des Weiteren ist zwischen dem Anodenanschluss und dem Gate eines der MOS-Transistoren eine Zenerdiode als Überspannungsschutz des Kondensators vorgesehen. Ein weiterer der MOS-Transistoren dient als Überspannungsschutz für einen anderen MOS-Transistor.

### Vorteile der Erfindung

Eine Gleichrichterschaltung mit den im Anspruch 1 angegebenen Merkmalen weist demgegenüber den Vorteil auf, dass der Leistungsverlust reduziert ist und aus diesem Grund der Aufwand für eine Kühlung ebenfalls reduziert werden kann.

Dies wird im Wesentlichen dadurch erreicht, dass in einer Gleichrichterbrücke anstelle von Silizium-PN-Dioden Gleichrichterschaltungen gemäß der Erfindung verwendet werden, wobei jede Silizium-PN-Diode der Gleichrichterbrücke durch eine derartige Gleichrichterschaltung ersetzt werden kann. Schaltungstechnische Veränderungen des Gesamtsystems sind nicht notwendig. Die Gleichrichterschaltungen gemäß der Erfindung benötigen keine separaten Stromversorgungen und auch keine separaten Signaleingänge.

Die Flussspannungen von Silizium-PN-Dioden lassen sich beim Gleichrichterbetrieb üblicherweise nicht unter ca. 1 1 V absenken. Durch die Verwendung von Gleichrichterschaltungen gemäß der Erfindung anstelle von Silizium-PN-Dioden sind die Flussspannungen auf bis zu ca. 25 mV absenkbar. Damit ist es möglich, die Leistungsverluste der Gleichrichter und den Aufwand für deren Kühlung deutlich zu reduzieren.

Weitere vorteilhafte Eigenschaften der Erfindung ergeben sich aus der nachfolgenden Erläuterung von Ausführungsbeispielen anhand der Figuren 2, 5, 6 und 7.

### Zeichnung

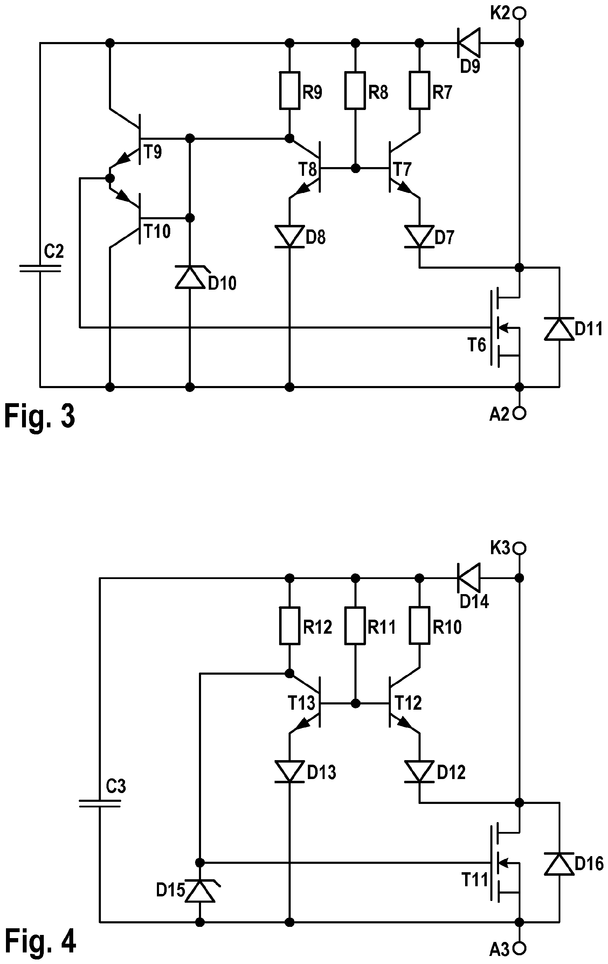

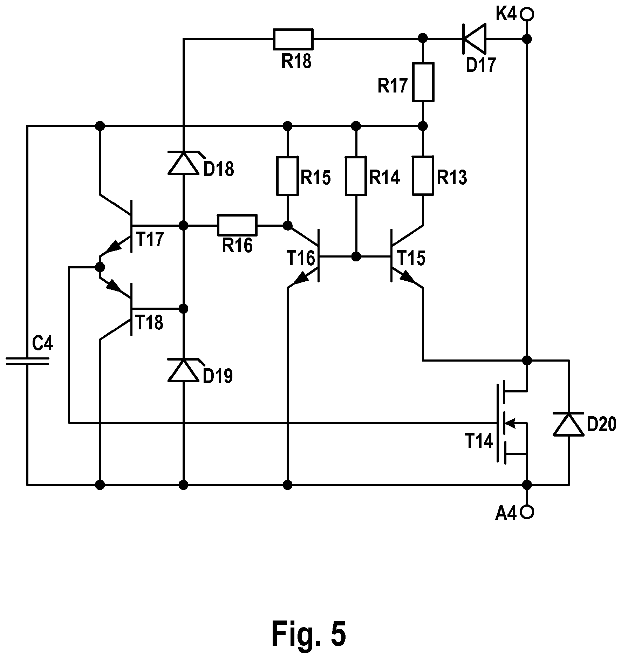

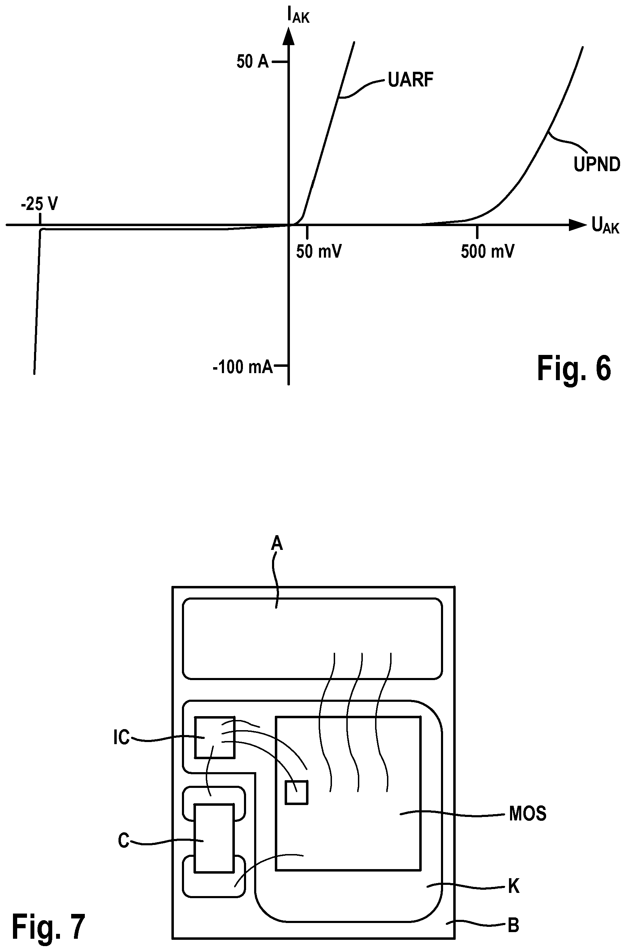

Die Figur 2 zeigt eine Gleichrichterschaltung gemäß einem ersten Ausführungsbeispiel für die Erfindung. Die Figur 3 zeigt eine Gleichrichterschaltung gemäß einem zweiten Ausführungsbeispiel für die Erfindung. Die Figur 4 zeigt eine Gleichrichterschaltung gemäß einem dritten Ausführungsbeispiel für die Erfindung. Die Figur 5 zeigt eine Gleichrichterschaltung gemäß einem vierten Ausführungsbeispiel für die Erfindung. Die Figur 6 zeigt beispielhaft die Strom-Spannungskennlinie einer Silizium-PN-Diode und die Strom-Spannungskennlinie einer Gleichrichterschaltung gemäß der Erfindung. Die Figur 7 veranschaulicht eine Realisierung einer Gleichrichterschaltung gemäß der Erfindung in Form eines elektronischen Bauelementes.

### Beschreibung

Die Figur 2 zeigt eine Gleichrichterschaltung gemäß einem ersten Ausführungsbeispiel für die Erfindung.

Die in der Figur 2 dargestellte Gleichrichterschaltung kann anstelle einer Silizium-PN-Diode beispielsweise in einer Gleichrichterbrücke zum Einsatz kommen. Sie weist ebenso wie eine Silizium-PN-Diode einen Kathodenanschluss K1 und einen Anodenanschluss A1 auf. Der MOS-Transistor T1 und die Inversdiode D6 sind parallel geschaltet und bilden technologisch bedingt in dieser Verschaltung zusammen ein mikroelektronisches Bauelement.

Die in der Figur 2 gezeigte Gleichrichterschaltung weist einen symmetrisch aufgebauten Differenzverstärker auf, der von den Transistoren T2 und T3 und Widerständen R1, R2 und R3 gebildet wird. Ein erster Eingang dieses Differenzverstärkers ist über eine Diode D1 mit dem Kathodenanschluss K1 und dem Drainanschluss des MOS-Transistors T1 verbunden. Ein zweiter Eingang dieses Differenzverstärkers ist über eine Diode D2 mit dem Anodenanschluss A1 verbunden. Dieser Differenzverstärker verstärkt die zwischen dem Kathodenanschluss K1 und dem Anodenanschluss A1 der Gleichrichterschaltung vorliegende Potentialdifferenz. Wegen des symmetrischen Aufbaus des Differenzverstärkers wirken sich Temperaturunterschiede und Alterungseffekte nur im geringem Umfang auf die Eigenschaften des Differenzverstärkers aus.

Das Ausgangssignal des Differenzverstärkers steht am Kollektor des Transistors T3 zur Verfügung und wird über einen Widerstand R4 an den Eingang einer Stromverstärkerstufe weitergegeben. Diese Stromverstärkerstufe besteht aus den Transistoren T4 und T5, deren Basen zusammengeschaltet sind. Die Zenerdiode D5 wirkt als Schutzelement für den Transistor T1 und schützt dessen Gate vor Überspannungen.

Beim Gleichrichten einer Wechselspannung liegt zwischen dem Kathodenanschluss K1 und dem Anodenanschluss A1 eine Wechselspannung der Frequenz f an. Bei positivem Potential am Kathodenanschluss K1 ist der MOS-Transistor T1 mit seiner integrierten Inversdiode D6 im Sperrbetrieb und der Kondensator C1 kann sich über die Diode D3 und den Widerstand R5 aufladen. Die am Kondensator C1 anliegende Spannung dient der Versorgung der weiteren Bauteile der Gleichrichterschaltung.

Ist das elektrische Potential am Kathodenanschluss K1 hingegen negativer als das elektrische Potential am Anodenanschluss A1 der Gleichrichterschaltung, dann ist die Gate-Source-Spannung des MOS-Transistors T1 positiv und höher als dessen Schwellenspannung. Der MOS-Transistor T1 ist bei diesen Bedingungen leitend, wobei ein Stromfluss mit dieser Stromrichtung nur einen geringen Spannungsabfall verursacht.

Ist das elektrische Potential am Kathodenanschluss K1 der Gleichrichterschaltung wieder positiver als das elektrische Potential am Anodenanschluss A1 der Gleichrichterschaltung, dann ist die Gate-Source-Spannung des MOS-Transistors T1 kleiner als dessen Schwellenspannung. Bei diesen Bedingungen sperrt der MOS-Transistor T1. Aus diesem Grund ist der Stromfluss durch den MOS-Transistor T1 nur sehr gering.

Ist das elektrische Potential am Kathodenanschluss K1 der Gleichrichterschaltung positiver als das elektrische Potential am Anodenanschluss A1 der Gleichrichterschaltung und übersteigt diese Potentialdifferenz einen durch die Zenerdiode D4 eingestellten Wert, dann wird das Eingangs-Potential der aus den Transistoren T4 und T5 bestehenden Stromverstärkerstufe angehoben. Dadurch erhöht sich auch die Gate-Source-Spannung des MOS-Transistors T1 und es kommt zu einem Stromfluss zwischen Drain und Source des MOS-Transistors T1. Dieser Stromfluss begrenzt bei den gegebenen Bedingungen die elektrische Potentialdifferenz zwischen dem Kathodenanschluss K1 und dem Anodenanschluss A1 der Gleichrichterschaltung auf einen vorbestimmten Wert. Dieses Merkmal der Begrenzung der Potentialdifferenz stellt eine Spannungsklammerung dar und bildet in speziellen Fällen einen Loaddumpschutz.

Die Figur 3 zeigt eine Gleichrichterschaltung gemäß einem nicht erfindungsgemäßen Ausführungsbeispiel . Der Aufbau und die Funktionalität der in der Figur 3 dargestellten Gleichrichterschaltung stimmen mit dem Aufbau und der Funktionalität der in der Figur 2 gezeigten Gleichrichterschaltung weitgehend überein. Die in der Figur 3 gezeigte Gleichrichterschaltung unterscheidet sich von der in der Figur 2 gezeigten Gleichrichterschaltung lediglich dadurch, dass die Basen der beiden Transistoren T9 und T10, die die Stromverstärkerstufe bilden, nicht über eine Zenerdiode und einen Widerstand mit der Kathode der Diode D9 verbunden sind. Folglich weist das in der Figur 3 gezeigte Ausführungsbeispiel das Merkmal der Begrenzung der Potentialdifferenz zwischen dem Kathodenanschluss K2 und dem Anodenanschluss A2 der Gleichrichterschaltung, d. h. das Merkmal der Spannungsklammerung, nicht auf.

Die Figur 4 zeigt eine Gleichrichterschaltung gemäß einem nicht erfindungsgemäßen Ausführungsbeispiel. Der Aufbau und die Funktionalität der in der Figur 4 dargestellten Gleichrichterschaltung stimmen mit dem Aufbau und der Funktionalität der in der Figur 2 gezeigten Gleichrichterschaltung weitgehend überein. Die in der Figur 4 gezeigte Gleichrichterschaltung unterscheidet sich von der in der Figur 2 gezeigten Gleichrichterschaltung dadurch, dass die Funktionsmerkmale der Spannungsklammerung und der Stromverstärkung nicht vorgesehen sind. Die Ansteuerung des Steuereingangs bzw. des Gateanschlusses des MOS-Transistors T11 erfolgt direkt vom Ausgang des Differenzverstärkers, der bei dem in der Figur 4 gezeigten Ausführungsbeispiel von den Transistoren T12 und T13 und den Widerständen R10, R11 und R12 gebildet wird.

Bei diesem Ausführungsbeispiel kann sich durch den Verzicht auf die Stromverstärkerstufe bedingt durch die Dimensionierung der weiteren Bauteile der Gleichrichterschaltung die Stromaufnahme der Schaltung erhöhen. Weiterhin kann sich dadurch auch die maximale Frequenz f der gleichzurichtenden Spannung reduzieren, da die Aufladung und Entladung des Gates des MOS-Transistors T11 bei diesen Bedingungen langsamer erfolgt.

Die Figur 5 zeigt eine Gleichrichterschaltung gemäß einem vierten Ausführungsbeispiel für die Erfindung. Der Aufbau und die Funktionalität der in der Figur 5 dargestellten Gleichrichterschaltung stimmen mit dem Aufbau und der Funktionalität der in der Figur 2 gezeigten Gleichrichterschaltung weitgehend überein. Die in der Figur 5 gezeigte Gleichrichterschaltung unterscheidet sich von der in der Figur 2 gezeigten Gleichrichterschaltung dadurch, dass der erste Eingang des Differenzverstärkers T15, T16, R13, R14, R15 nicht über eine Diode, sondern direkt an den Kathodenanschluss K4 der Gleichrichterschaltung und den Drainanschluss des MOS-Transistors T14 angeschlossen ist, und weiterhin dadurch, dass der zweite Eingang dieses Differenzverstärkers nicht über eine Diode, sondern direkt mit dem Anodenanschluss A4 der Gleichrichterschaltung verbunden ist. Bei diesem Ausführungsbeispiel wird davon ausgegangen, dass die Basis-Emitter-Inverssperrfähigkeit des Transistors T15 des Differenzverstärkers stets größer ist als die während des Betriebes der Gleichrichterschaltung maximal daran anliegenden Spannungen.

Die Figur 6 zeigt beispielhaft die Strom-Spannungskennlinie einer Silizium-PN-Diode und die Strom-Spannungskennlinie einer Gleichrichterschaltung gemäß der Erfindung. Aus der Figur 6 ist ersichtlich, dass die Flussspannung UARF einer Gleichrichterschaltung gemäß der Erfindung im Vergleich zur Flussspannung UPND einer Silizium-PN-Diode vergleichsweise gering ist.

Die Figur 7 zeigt eine Realisierung einer Gleichrichterschaltung gemäß der Erfindung in Form eines elektronischen Bauelementes. Gleichrichterschaltungen gemäß der Erfindung lassen sich aus diskreten Bauelementen oder aus speziell entwickelten Bauelementen zusammensetzen. Aus der Figur 7 ist ein derartiges verlustarmes elektronisches Bauelement ersichtlich, das aus einem MOS-Transistor MOS, einem Kondensator C, einem Baugruppenträger B und einer integrierten Schaltung IC besteht. Die integrierte Schaltung IC beinhaltet alle elektronischen Bauelemente der Gleichrichterschaltung mit Ausnahme des MOS-Transistors und des Kondensators. Das elektronische Bauelement gemäß Figur 7 ist wie eine Silizium-PN-Diode verschaltbar. Dabei entspricht der Anodenanschluss A des elektronischen Bauelementes dem Anodenanschluss einer Silizium-PN-Diode und der Kathodenanschluss K des elektronischen Bauelementes dem Kathodenanschluss einer Silizium-PN-Diode.

## Patentansprüche

1. Gleichrichterschaltung, welche einen Kathodenanschluss (K1, K4), einen Anodenanschluss (A1, A4) und eine zwischen dem Kathodenanschluss und dem Anodenanschluss vorgesehene elektronische Schaltung aufweist, welche einen MOS-Transistor (T1, T4) mit integrierter Inversdiode (D6, D20), einen Kondensator (C1, C4) und einen Differenzverstärker (T2/T15, T3/T16, R1/R13, R2/R14, R3/R15) enthält, wobei der erste Eingang des Differenzverstärkers mit dem Kathodenanschluss und der zweite Eingang des Differenzverstärkers mit dem Anodenanschluss verbunden ist, **dadurch gekennzeichnet, dass** sie eine Stromverstärkerstufe (T4/T17, T5/T18) aufweist, deren Eingang mit dem Ausgang des Differenzverstärkers und deren Ausgang mit dem Steuereingang des MOS-Transistor (T1/T4) verbunden ist, dass sie einen Begrenzer (D4/D18) aufweist, der die Potentialdifferenz zwischen dem Kathodenanschluss (K1/K4) und dem Anodenanschluss (A1/A4) auf einen vorgegebenen Wert begrenzt, und dass sie als Schutzelement für das Gate des MOS-Transistors (T1/T4) mindestens ein Überspannungsschutzelement (D5/D19) aufweist, das zwischen dem Sourceanschluss des MOS-Transistors (T1/T4) und dem Eingang der Stromverstärkerstufe (T4/T17, T5/T18) angeordnet ist.

2. Gleichrichterschaltung nach Anspruch 1, **dadurch gekennzeichnet, dass** der Kondensator (C1/C4) über eine Reihenschaltung einer Diode (D3/D17) und eines Widerstandes (R5/R17) mit dem Kathodenanschluss (K1/ K4) verbunden ist.

3. Gleichrichterschaltung nach einem der vorhergehenden Ansprüche, **dadurch gekennzeichnet, dass** der erste Eingang des Differenzverstärkers mit dem Kathodenanschluss (K1) über eine Diode (D1) verbunden ist und der zweite Eingang des Differenzverstärkers mit dem Anodenanschluss (A1) ebenfalls über eine Diode (D2) verbunden ist.

4. Gleichrichterschaltung nach einem der vorhergehenden Ansprüche, **dadurch gekennzeichnet, dass** der Differenzverstärker symmetrisch aufgebaut ist.

5. Gleichrichterschaltung nach einem der vorhergehenden Ansprüche, **dadurch gekennzeichnet, dass** die Stromverstärkerstufe zwei Transistoren (T4/T17, T5/T18) aufweist, deren Steueranschlüsse miteinander verbunden sind.

6. Gleichrichterschaltung nach einem der vorhergehenden Ansprüche, **dadurch gekennzeichnet, dass** die Stromverstärkerstufe zwei Transistoren (T4/T17, T5/T18) aufweist, deren Emitter miteinander verbunden sind.

7. Elektronisches Bauelement zur Gleichrichtung von Wechselspannungen, das mindestens eine Gleichrichterschaltung gemäß einem der Ansprüche 1 - 6 aufweist.

8. Elektronisches Bauelement nach Anspruch 7, **dadurch gekennzeichnet, dass** es mindestens einen Baugruppenträger (B), mindestens einen MOS-Transistor (MOS), mindestens eine integrierte Schaltung (IC) und mindestens einen Kondensator (C) enthält.

9. Generator zur Spannungsversorgung eines Kraftfahrzeugs, der mindestens eine Gleichrichterschaltung nach einem der Ansprüche 1-6 enthält.

10. Generator zur Spannungsversorgung eines Kraftfahrzeugs, der mindestens ein elektronisches Bauelement nach Anspruch 7 oder 8 enthält.

## Claims

1. Rectifier circuit, which has a cathode connection (K1, K4), an anode connection (A1, A4) and an electronic circuit provided between the cathode connection and the anode connection, said electronic circuit containing a MOS transistor (T1, T4) with integrated inverse diode (D6, D20), a capacitor (C1, C4) and a differential amplifier (T2/T15, T3/T16, R1/R13, R2/R14, R3/R15), wherein the first input of the differential amplifier is connected to the cathode connection and the second input of the differential amplifier is connected to the anode connection, **characterized in that** said rectifier circuit has a current amplifier stage (T4/T17, T5/T18), the input of which is connected to the output of the differential amplifier and the output of which is connected to the control input of the MOS transistor (T1/T4), **in that** said rectifier circuit has a limiter (D4/D18), which limits the potential difference between the cathode connection (K1/K4) and the anode connection (A1/A4) to a prescribed value, and **in that** said rectifier circuit has at least one overvoltage protection element (D5/D19) as protection element for the gate of the MOS transistor- (T1/T4), said overvoltage protection element being arranged between the source connection of the MOS transistor (T1/T4) and the input of the current amplifier stage (T4/T17, T5/T18).

2. Rectifier circuit according to Claim 1, **characterized in that** the capacitor (C1/C4) is connected to the cathode connection (K1/K4) by means of a series circuit of a diode (D3/D17) and a resistor (R5/R17).

3. Rectifier circuit according to either of the preceding claims, **characterized in that** the first input of the differential amplifier is connected to the cathode connection (K1) by means of a diode (D1) and the second input of the differential amplifier is likewise connected to the anode connection (A1) by means of a diode (D2).

4. Rectifier circuit according to one of the preceding claims, **characterized in that** the differential amplifier is of symmetrical design.

5. Rectifier circuit according to one of the preceding claims, **characterized in that** the current amplifier stage has two transistors (T4/T17, T5/T18), the control connections of which are connected to one another.

6. Rectifier circuit according to one of the preceding claims, **characterized in that** the current amplifier stage has two transistors (T4/T17, T5/T18), the emitters of which are connected to one another.

7. Electronic component for rectifying AC voltages, which has at least one rectifier circuit according to one of Claims 1-6.

8. Electronic component according to Claim 7, **characterized in that** said electronic component contains at least one assembly carrier (B), at least one MOS transistor (MOS), at least one integrated circuit (IC) and at least one capacitor (C).

9. Generator for supplying voltage to a motor vehicle, which contains at least one rectifier circuit according to one of Claims 1-6.

10. Generator for supplying voltage to a motor vehicle, which contains at least one electronic component according to Claim 7 or 8.

## Revendications

1. Circuit redresseur, lequel possède une borne de cathode (K1, K4), une borne d'anode (A1, A4) et un circuit électronique disposé entre la borne de cathode et la borne d'anode, lequel contient un transistor MOS (T1, T4) muni d'une diode inverse intégrée (D6, D20), un condensateur (C1, C4) et un amplificateur différentiel (T2/T15, T3/T16, R1/R13, R2/R14, R3/R15), la première entrée de l'amplificateur différentiel étant reliée à la borne de cathode et la deuxième entrée de l'amplificateur différentiel étant reliée à la borne d'anode, **caractérisé en ce qu'**il possède un étage amplificateur de courant (T4/T17, T5/T18) dont l'entrée est reliée à la sortie de l'amplificateur différentiel et dont la sortie est reliée à l'entrée de commande du transistor MOS (T1, T4), **en ce qu'**il possède un limiteur (D4/D18) qui limite la différence de potentiel entre la borne de cathode (K1, K4) et la borne d'anode (A1, A4) à une valeur prédéfinie et **en ce qu'**il possède au moins un élément de protection conte les surtensions (D5/D19) en tant qu'élément de protection pour la gâchette du transistor MOS (T1, T4), lequel est disposé entre la borne de source du transistor MOS (T1, T4) et l'entrée de l'étage amplificateur de courant (T4/T17, T5/T18).

2. Circuit redresseur selon la revendication 1, **caractérisé en ce que** le condensateur (C1, C4) est relié à la borne de cathode (K1, K4) par le biais d'un circuit série constitué d'une diode (D3/D17) et d'une résistance (R5/R17).

3. Circuit redresseur selon l'une des revendications précédentes, **caractérisé en ce que** la première entrée de l'amplificateur différentiel est reliée à la borne de cathode (K1) par le biais d'une diode (D1) et la deuxième entrée de l'amplificateur différentiel est reliée à la borne d'anode (A1) également par le biais d'une diode (D2) .

4. Circuit redresseur selon l'une des revendications précédentes, **caractérisé en ce que** l'amplificateur différentiel possède une structure symétrique.

5. Circuit redresseur selon l'une des revendications précédentes, **caractérisé en ce que** l'étage amplificateur de courant possède deux transistors (T4/T17, T5/T18) dont les bornes de commande sont reliées entre elles.

6. Circuit redresseur selon l'une des revendications précédentes, **caractérisé en ce que** l'étage amplificateur de courant possède deux transistors (T4/T17, T5/T18) dont les émetteurs sont reliés entre eux.

7. Composant électronique destiné à redresser des tensions alternatives, lequel possède au moins un circuit redresseur selon l'une des revendications 1 à 6.

8. Composant électronique selon la revendication 7, **caractérisé en ce qu'**il contient au moins un porte-module (B), au moins un transistor MOS (MOS), au moins un circuit intégré (IC) et au moins un condensateur (C).

9. Alternateur destiné à la génération de tension d'un véhicule automobile, lequel contient au moins un circuit redresseur selon l'une des revendications 1 à 6.

10. Alternateur destiné à la génération de tension d'un véhicule automobile, lequel contient au moins un composant électronique selon la revendication 7 ou 8.
